# EUROPÄISCHE PATENTANMELDUNG

(11) **EP 0 624 901 A1**
(43) Veröffentlichungstag der Anmeldung: **17.11.1994**
(21) Anmeldenummer: 94106981.7
(22) Anmeldetag: 04.05.1994
(51) Int. Cl.: H01L 23/29, C23C 16/26

(54) **Halbleiterbauelement mit Passivierungsschicht**

(30) Priorität: 13.05.1993 DE 4316121
(71) Anmelder: EUPEC Europäische Gesellschaft für Leistungshalbleiter mbH & Co. KG, D-59581 Warstein (DE); SIEMENS AKTIENGESELLSCHAFT, D-80333 München (DE)
(72) Erfinder: Hammerschmidt, Albert, Dr. Dipl.-Chem., D-91056 Erlangen (DE); Schmidt, Gerhard, Dr. Dipl.-Phys., D-91301 Forchheim (DE); Schulte, Rolf, D-91056 Erlangen (DE)
(74) Vertreter: Fuchs, Franz-Josef, Dr.-Ing.

(57) **Zusammenfassung**

Aus amorphem wasserstoffhaltigen Kohlenstoff bestehende Passivierungsschichten erfüllen viele Anforderungen. Reine a-C:H-Schichten sind für p-dotierte Substrate jedoch nicht optimal, da sich eine Inversionsschicht ausbilden kann. Dies wird durch eine Bordotierung verhindert, die zwischen 0,1 ‰ und 4 % betragen kann.

## Beschreibung

Die Erfindung bezieht sich auf ein Halbleiterbauelement mit einem Halbleiterkörper mit mindestens einem an die Oberfläche des Halbleiterkörpers tretenden pn-Übergang und mit einer Passivierungsschicht, die aus mit Bor dotiertem amorphem wasserstoffhaltigem Kohlenstoff (a-C:H) besteht und die mindestens den an die Oberflache tretenden Teil des pn-Übergangs bedeckt. Ein solches Halbleiterbauelement ist z.B. in der DE 40 13 435 A1 beschrieben worden. Dort ist angegeben, daß als Passivierungsschicht außer im Vakuum aufgedampftem, mit Bor dotiertem Silizium auch amorpher wasserstoffhaltiger, mit Bor dotierter Kohlenstoff (a-C:H) verwendet werden kann.

Eine solche Schicht aus amorphem, wasserstoffhaltigem Kohlenstoff erfüllt die an eine Passivierungsschicht zu stellenden Anforderungen recht gut. So ist der spezifische Widerstand größer als 10⁸ ohm cm, die Zustandsdichte ist einige 10¹⁹ cm⁻³ eV⁻¹, die thermische Belastbarkeit bis zu 290 °C, außerdem hat sie eine gute Dichtheit gegen Feuchtigkeit. Probleme können dadurch entstehen, daß die Anpassung der Schicht an p-dotierte Bereiche des Halbleiterkörpers nicht optimal ist. Hier kann sich, vermutlich durch eine Inversionsschicht bedingt, bei Thyristoren eine Abnahme der Sperrfähigkeit in Durchlaßrichtung ergeben.

Der Erfindung liegt die Aufgabe zugrunde, ein Halbleiterbauelement der eingangs erwähnten Gattung derart weiterzubilden, daß die Passivierungsschicht auch an p-dotierte Halbleiterschichten angepaßt ist.

Diese Aufgabe wird dadurch gelost, daß der Borgehalt gewichtsmäßig zwischen 0,01 ‰ und 4 % beträgt.

Vorzugsweise hat die Passivierungsschicht eine Zustandsdichte großer 10¹⁸ cm⁻³ eV⁻¹, einen spezifischen Widerstand größer als 10⁸ Ohm cm und einen Bandabstand zwischen 0,7 und 1,1 eV. Die bevorzugte Dicke der Passivierungsschicht liegt zwischen 0,02 und 3 µm.

Die Passivierungsschicht gemäß der Erfindung läßt sich z.B. aus einem Hochfrequenz-Niederdruckplasma abscheiden, das in einem Gemisch aus gasförmigen, organischen, Kohlenstoff und Wasserstoff enthaltenden Verbindungen und gasförmigen organischen Borverbindungen erzeugt wird. Der Druck kann dabei zwischen 0,05 und 1 mbar betragen, die spezifische Leistungsdichte zwischen 0,5 und 10 W/cm². Als überlagerte Gleichspannung bildet sich bei entsprechender geometrischer Ausbildung des Abscheidereaktors (Flächenverhältnis Anode: Katode größer 2:1) eine selfbias von etwa -800 bis -900 V aus. Das Plasma kann auch durch Mikrowellen angeregt werden.

An wasserstoffhaltigen Kohlenstoffverbindungen werden z.B. Methan, Ethen, Azethylen, Propan, Butan verwendet. Daneben kommen andere, beim genannten Abscheidedruck gasförmige Kohlenwasserstoffe wie Zyklohexan, Benzol, Tetralin oder auch sauerstoffhaltige organische Verbindungen wie Ester oder Ether in Betracht. Vorzugsweise werden Alkane, Alkene, Alkine oder Arene verwendet, da diese Verbindungen ausschließlich Kohlenstoff und Wasserstoff enthalten.

Den gasförmigen, organischen, Kohlenstoff und Wasserstoff enthaltenden Verbindungen werden als gasförmige Borverbindungen z.B. Borsäureester, Carborane oder Borane beigemengt. Die Verwendung von organischen Borverbindungen ist besonders vorteilhaft, weil hier die verfahrenstechnischen Probleme von Bor-Wasserstoffverbindungen wie Selbstentzündung an Luft nicht auftreten. Die Verwendung von Borsäureester baut Sauerstoff in die Passivierungsschicht ein. Dies kann für die Passivierungswirkung vorteilhaft sein.

Die beschriebenen Verfahren zum Abscheiden von bordotierten amorphen wasserstoffhaltigen Kohlenstoffverbindungen können auch derart modifiziert werden, daß die Zufuhr der Bor enthaltenden Verbindung nach Abscheiden einer gewissen Schichtstärke beendet wird. Danach wird dann eine borfreie Schicht abgeschieden. Das Dickenverhältnis der borhaltigen zur borfreien Schicht kann dabei von 0,5:99,5 bis 99,5:0,5 eingestellt werden.

Es ist günstig, wenn die Passivierungsschicht nach der Abscheidung bei einer Temperatur zwischen 200 und 350 °C getempert wird. Der Halbleiterkörper selbst wird während des Abscheidens auf einer Temperatur unter 300 °C gehalten.

### Ausführungsbeispiel:

Die Anlage zur Herstellung des Plasmas hat zwei Elektroden mit unterschiedlichen Flächen, wobei die größere geerdet und die kleinere über ein Anpassungsnetzwerk mit einem Hochfrequenzgenerator verbunden ist. In den Reaktor wird unter einem Druck von 0,2 mbar ein Methan-Borsäuretrimethylester (B(OCH₃)₃-Gemisch eingeleitet. Das Durchflußverhältnis beträgt 20:1. Auf der kleineren Elektrode, der Katode, befindet sich das zu beschichtende Substrat in Form eines Halbleiterkörpers eines Thyristors mit dem bekannten, positiv/negativ abgeschrägten Rand. Das Plasma wird nun durch Zündung erzeugt, wobei die Leistung derart gewählt wird, daß sich eine gemessene Spannung zwischen Anode und Katode (selfbias) von -800 V einstellt. Die hierzu benötigte spezifische Leistung ist 2,8 W/cm². Nach 2,5 min Abscheidung wird der Zufluß des Borsäuremethylesters gestoppt und weitere 2,5 min reines a-H:C abgeschieden. Damit ergibt sich eine Schicht mit einer Dicke von 0,6 µm, einem optischen Bandabstand von 0,8 bis 0,9 eV und einer zustandsdichte von ca. 10¹⁹ cm⁻³ eV⁻¹. Die derartig beschichteten Halbleiterkörper werden dann für drei Stunden bei 270 °C getempert. Sie zeigen stabile Kennlinien in der Durchlaßrichtung. Der gemessene gewichtsmäßige Borgehalt betrug dabei 0,45%. Außerdem wurde ein Sauerstoffgehalt von etwa 10 Gewichts-% gemessen.

## Patentansprüche

1. Halbleiterbauelement mit einem Halbleiterkörper mit mindestens einem an die Oberfläche des Halbleiterkörpers tretenden pn-Übergang und mit einer Passivierungsschicht, die aus mit Bor dotiertem amorphem wassserstoffhaltigem Kohlenstoff (a-C:H) besteht und die mindestens den an die Oberfläche tretenden Teil des pn-Übergangs bedeckt,
**dadurch gekennzeichnet,** daß der Borgehalt gewichtsmäßig zwischen 0,01 ‰ und 4 % beträgt.

2. Halbleiterbauelement nach Anspruch 1,
**dadurch gekennzeichnet,** daß die Passivierungsschicht eine Zustandsdichte größer als 10¹⁸ cm⁻³ eV⁻¹, einen spezifischen Widerstand größer als 10⁸ Ohm cm und einen Bandabstand zwischen 0,7 und 1,1 eV hat.

3. Halbleiterbauelement nach Anspruch 1 oder 2,
**dadurch gekennzeichnet,** daß die Passivierungsschicht eine Dicke zwischen 0,02 und 3 µm hat.

4. Halbleiterbauelement nach Anspruch 1,
**dadurch gekennzeichnet,** daß die Passivierungsschicht Sauerstoff bis zu einem Gewichtsanteil von 15 % enthält.

5. Verfahren zum Herstellen einer Passivierungsschicht nach einem der Ansprüche 1 bis 4,
**dadurch gekennzeichnet,** daß die Passivierungsschicht aus einem Hochfrequenz-Niederdruck-Plasma abgeschieden wird, das in einem Gemisch aus gasförmigen, organischen, Kohlenstoff und Wasserstoff enthaltenden Verbindungen und gasförmigen, organischen Borverbindungen erzeugt wird.

6. Verfahren nach Anspruch 5,
**dadurch gekennzeichnet,** daß die Passivierungsschicht nach der Abscheidung bei einer Temperatur zwischen 200 und 350 °C getempert wird.

7. Verfahren nach Anspruch 5 oder 6,
**dadurch gekennzeichnet,** daß vor dem Erreichen der gwünschten Schichtdicke die Zugabe der Borverbindung beendet wird und daß ein Dickenverhältnis der borhaltigen zur borfreien Schicht von 0,5:99,5 bis 99,5:0,5 eingestellt wird.

8. Verfahren nach einem der Ansprüche 4 bis 7,
**dadurch gekennzeichnet,** daß als gasförmige, organische Kohlenstoff und Wasserstoff enthaltende Verbindungen Alkane, Alkene, Alkine oder Arene verwendet werden.

9. Verfahren nach einem der Ansprüche 5 bis 8,
**dadurch gekennzeichnet,** daß als gasförmige Borverbindungen Borsäureester, Carborane oder Borane verwendet werden.

10. Verfahren nach Anspruch 5,
**dadurch gekennzeichnet,** daß das Plasma durch Hochfrequenz- oder Mikrowellenanregung erzeugt wird.

11. Verfahren nach einem der Ansprüche 5 bis 10,
**dadurch gekennzeichnet,** daß die Passivierungsschicht auf einem Halbleiterkörper abgeschieden wird, dessen Temperatur unter 300 °C gehalten wird.
